# EUROPEAN PATENT APPLICATION

(11) **EP 3 920 240 A1**
(43) Date of publication of application: **08.12.2021**
(21) Application number: 19912950.3
(22) Date of filing: 27.12.2019
(51) Int. Cl.: H01L 31/048, H01L 31/0203, H01L 31/04, H01L 51/00, H01L 51/42, H01G 9/20, H02S 40/36

(54) **PHOTOVOLTAIC CELL, METHOD FOR MANUFACTURING AN ENCAPSULATED PHOTOVOLTAIC CELL, ELECTRICAL CONNECTION UNIT FOR A PHOTOVOLTAIC TILE, AND PHOTOVOLTAIC TILE**

(30) Priority: 30.01.2019 BR 102019001956; 14.10.2019 BR 132019021524
(71) Applicant: Tégula Soluções para Telhados Ltda, 12953-162 Atibaia (BR)
(72) Inventor: ABRÃO, Claiton, 37800-000 Guaxupé (BR); INÁCIO, Rodrigo Angelo, 05423-040 São Paulo (BR); LOPES, Luiz Antonio, 05305-070 São Paulo (BR)
(74) Representative: Winter, Brandl - Partnerschaft mbB
(86) International application number: PCT/BR2019/050573
(87) International publication number: WO 2020/154784

(57) **Abstract**

A p-n photovoltaic cell (10) comprising a crystalline-silicon structure (11) coated with a conductive film (12) formed using a p-type dopant solution and an n-type dopant solution, the p-type and n-type dopant solutions including carotenoid components. A method for manufacturing an encapsulated p-n photovoltaic cell using the p-n photovoltaic cell (10) and the use of these encapsulated photovoltaic cells (19) forming modules (15) that are used to form, with photovoltaic tiles (20), single parts with electrical energy generation and coverage functions. An electrical connection unit for a photovoltaic tile (20) that is used to simply and safely conduct the electrical energy generated by the photovoltaic tiles (20) to an inverter.

## Description

The present invention relates to a p-n type photovoltaic cell, containing agents that provide sun protection factor for decreasing the thermal coefficient and, consequently, better efficiency in electrical conductivity. The invention also refers to the manufacturing process of this encapsulated photovoltaic cell, to an electrical connection assembly for photovoltaic tiles, responsible for conducting, in a simple and safe way, the electric power generated by the photovoltaic tiles to an inverter and the photovoltaic tile comprising encapsulated photovoltaic cells and the electrical connection assembly.

### Description of the state of the art

Photovoltaic cells are devices made of semiconductor materials, which convert solar radiation into electrical energy through the photoelectric effect. Photovoltaic tiles, on the other hand, are construction elements used to cover houses and buildings that contain one or more photovoltaic cells.

Several types of photovoltaic cells are known from the prior art. They are differentiated by the material they are made of, the most common of which is crystalline silicon, although other nobler materials of greater value are also adopted in the manufacture of this device, such as tin/indium oxide (OEI) coated with titanium dioxide nanoparticles (TiO2) and zinc oxide (ZnO).

Despite being considered a "clean" power generation device and, for that reason, there is great interest in its use on a large scale, since photovoltaic cells are made of semiconductor materials, they generally have low energy efficiency due to two main factors: (i) the excess of solar energy absorbed by these semiconductor materials, mainly ultraviolet spectrum energy, which leads to an increase in temperature of the cell resulting in reduced electrical conductivity; and (ii) the infrared spectrum also absorbed by the cell's semiconductor material in the form of solar radiation and which does not hold enough energy for electrical conductivity, resulting in a simple heat conversion that increases the cell temperature and results in a reduction in electrical conductivity.

In order to solve the problem of low electrical conductivity, several studies and developments in this technological area are being made.

In this sense, document BR 10 2012 027389-6 describes tiles in a Roman tile model or Plan model that comprise photovoltaic crystalline silicon cells doped with phosphorus and encapsulated in their structure forming a single handle. The assembled tile comprises, from the top to the bottom surface, layers of translucent resin, ethylene vinyl acetate (EVA) polymer, photovoltaic cell, EVA polymer as a backsheet layer, tile, and translucent resin.

Also, the paper by Gao et al. entitled "Photovoltaic response of carotenoid-sensitized electrode in aqueous solution: ITO coated with a mixture of TiO2 nanoparticles, carotenoid, and polyvinylcarbazole", for example, describes the treatment of tin/medium oxide semiconductors coated with titanium dioxide nanoparticles (OEI/ TiO₂) with canthaxanthin-based carotenoids and [5 ]-carotene to improve the efficiency of these semiconductor materials. This paper also teaches the action mechanism of carotenoids in this type of treatment. In this context, the canthaxanthin molecules present in these semiconductors absorb solar radiation by becoming energetically excited. In this situation, its electrons are donated to the conduction band of the tin/medium oxide with TiO₂ optimizing its electrical conductivity.

Also the paper by Zhuang et al. entitled "Natural- photosynthesis-inspired photovoltaic cells using carotenoid aggregates as electron donors, and chlorophyll derivatives as electron acceptors" reveals the treatment of tin/indium oxide (OEI) and molybdenum (III) oxide ( MoO3) photovoltaic cells, or OEI/MoO3, with lycopene-based carotenoids and chlorophyll pigments. This document also teaches the process of optimizing energy efficiency due to the presence of carotenoids, which act as electron donor molecules, and chlorophyll, acting as an electron acceptor molecule. The presence of these molecules creates a balance of holes and electron flux in these photovoltaic cells, improving their efficiency.

Muthusaamy's paper, entitled "Marine seaweed Sargassum wightii extract as a low-cost sensitizer for ZnO photoanode-based dye-sensitized solar cell" describes the use of seaweed extract comprising a mixture of pigments such as carotenoids, fucoxanthin and chlorophyll, to increase the energy efficiency of zinc oxide (ZnO) photoanodes, a type of semiconductor. In this paper the presence of these pigments improves the photovoltaic efficiency of this material.

Thus, it is possible to find in the state of the art research that makes use of carotenoids in undoped photovoltaic cells, as well as p-n type photovoltaic cells (doped with p-type and n-type dopants), but that do not comprise carotenoids.

Furthermore, in the usual photovoltaic tiles and panels, the connection between them for conducting the generated electric power is made through a photovoltaic cable that contains two protections: resistance to UVB, that is, to the ultraviolet rays that are transmitted from the Sun; and resistance to burning.

Also, these already known photovoltaic tiles and panels have junction box and single contact electrical connectors that are installed at the terminal of the electrical power conduction cables, in each panel or tile, intermediating the connection of the electrical power output cables with the inverter.

The junction box is usually applied to house a diode that prevents reverse current. The connectors, in turn, are used to avoid bad contacts in electrical connections. However, the presence of the usual junction boxes and electrical connectors increases the cost of the roof tiles and photovoltaic panels, as well as making the fabrication and assembly of the roofs more complex.

Therefore, there are already developments made towards building photovoltaic cells for use on roofs, such as tiles, without the use of electrical connectors at the cable terminals to conduct the electrical energy generated by these cells and without the use of junction boxes.

Document BR 10 2012 027389-6, for example, describes a polymeric composite tile fitted with photovoltaic cells that are arranged on the body of the tile. The system of association of the photovoltaic cell with the roof tile does not use junction boxes with the objective of reducing the manufacturing cost and facilitating the production process. Therefore, the busbar strips between the photovoltaic cells, energized with the electrical energy transformed by the cells, are soldered to an electrical harness for the connection and transfer of this electrical energy to the current inverter. In this way, the harness is used to connect the powered busbars of the photovoltaic cells in series and finally connect this series of photovoltaic cells to the inverter using a connector.

In this solution, a photovoltaic cell connector is no longer used, but it is still necessary to use it to connect the harness to the inverter. In addition, the association of the harness with the busbars of the photovoltaic cells is done with the use of welding, which does not simplify the installation of the covers since the product does not arrive finalized for installation, requiring welding.

Paper WO 2008/137966 brings a solution for a reliable structure and low-cost solar roofs. In this case, the cabling is reduced, leaving only the cable at the end of each row of photovoltaic cells and the junction box is eliminated. Also, the assembly of the electrical part of the roof tiles is done in such a way that the tiles are connected to each other and the final connections are made by rows of tiles instead of being connected tile by tile individually, each with a junction box and electrical connector.

In the configuration described in this document, the electrical connection is made by fitting the tab of one tile to the tab of the adjacent tile, so that the electrical connection only occurs when the tiles are mounted on the roof. There is no electrical harness connecting the tiles, the connectors are internal, one tile has a "male" connector while the adjacent tile has a "female" connector. When fitted the tiles close the electrical contact, eliminating the use of the junction box. The cabling is restricted only to the end of each tile line, for the inverter connection, but nothing is mentioned about eliminating the use of connectors on each of the tile lines when connected to the inverter.

It can be seen, therefore, that there is interest in simplifying the electrical connections in the assembly of photovoltaic tiles. In this sense, electrical simplification of the tiles is necessary, eliminating components that bring costs and difficulties in connections, without, however, resulting in unsafe installations that can generate risks of electric shock or fire.

### Objectives of the invention

Thus, the present invention aims to provide a p-n type photovoltaic cell comprising p-type and n-type dopants and agents that provide sun protection factor for decreasing the thermal coefficient, attributing to such photovoltaic cell increased electrical conductivity and increased efficiency in this electrical conductivity, respectively.

Another object of this invention is to provide a process for manufacturing an encapsulated p-n type photovoltaic cell, comprising doping steps containing agents that provide sun protection factor for decreasing the thermal coefficient and, consequently, increasing the efficiency in the electrical conductivity of this cell.

It is further an object of the present invention, to provide a photovoltaic tile, forming a single handle with the encapsulated photovoltaic cells so as to comprise roofing and power generation properties simultaneously.

Another object of this invention is to provide an electrical connection assembly for photovoltaic tiles capable of conducting, in a simple and safe manner, the electrical energy generated by a plurality of photovoltaic tiles to a current inverter.

It is also an object of the present invention to provide a photovoltaic tile provided with the electrical connection assembly for photovoltaic tiles.

### Brief description of the invention

The present invention has as its object, a p-n type photovoltaic cell comprising a crystalline silicon structure coated with a conductive film formed from a p-type dopant solution and an n-type dopant solution, the p-type and n-type dopant solutions comprising carotenoid components.

Another object of this invention is a process for manufacturing an encapsulated p-n type photovoltaic cell, comprising the following steps:
a) coating a plurality of crystalline silicon structures by a conductive film formed from p-type and n-type doping solutions comprising carotenoid components, forming a plurality of p-n type photovoltaic cells;
b) union of the plurality of photovoltaic cells of the p-n type by means of tin solder forming a module;
c) module encapsulation forming an encapsulated photovoltaic cell; and
d) electrical connection.

The present invention further has, as an object, an electrical connection assembly for photovoltaic tile, said photovoltaic tile having photovoltaic cells, the electrical connection assembly comprising: at least a first connector embedded in the photovoltaic tile and associated with electrical busbars of at least one photovoltaic cell; and at least a second connector connected to a pair of conductive wires, the at least one second connector being electrically associated with the at least one first connector so as to conduct the electrical energy generated by the at least one photovoltaic cell to an inverter element.

Also it is an object of this invention, a photovoltaic tile comprising a plurality of encapsulated photovoltaic cells and an electrical connection assembly for photovoltaic tiles.

### Short Description of Designs

Figure 1A - is a schematic sectional view of the p-n type photovoltaic cell subject of the present invention;
Figure 1B - is a schematic view of a plurality of p-n type photovoltaic cells associated with each other;
Figure 2 - is a perspective view of the photovoltaic tile, the subject of this invention;
Figure 3 - is a flow chart of the manufacturing process of the encapsulated photovoltaic cell, object of this invention;
Figure 4 - is a flow chart of the step in the manufacturing process of the encapsulated photovoltaic cell, more specifically the step of coating a plurality of crystalline silicon structures by a conductive film;
Figure 5 - is a schematic exploded view of the encapsulated photovoltaic cell;
Figure 6 - is a top view of the photovoltaic tile with the electrical connection assembly that is the subject of the present invention;
Figure 7 - is a bottom view of the photovoltaic tile with the electrical connection assembly that is the subject of the present invention;
Figure 8 - is a schematic sectional view of the photovoltaic tile with the electrical connection assembly that is the subject of the present invention;
Figure 8A - is a detail view of the first connector of the electrical connection assembly, embedded in the photovoltaic tile;
Figure 9 - is a schematic perspective view of the main conductor line of the electrical connection assembly that is the subject of the present invention;
Figure 9A - is a detail view of the main conductive thread of the electrical connection assembly that is the subject of the present invention;
Figure 10 - is a schematic perspective view of the secondary conductor line of the electrical connection assembly subject of the present invention;
Figure 11 - is a bottom view of a plurality of tiles connected to each other with the electrical connection set that is the object of the present invention;
Figure 12 - is a top view of a plurality of tiles connected with the electrical connection assembly that is the subject of the present invention;
Figure 13 - is a perspective view of a plurality of tiles connected with the electrical connection assembly that is the subject of the present invention;
Figure 14 - is a schematic view of the electrical connection diagram of the main conductor line of the electrical connection assembly that is the subject of the present invention; and
Figure 15 - is a schematic view of the electrical connection diagram of the secondary conductor line of the electrical connection assembly subject of the present invention.

### Detailed description of the invention

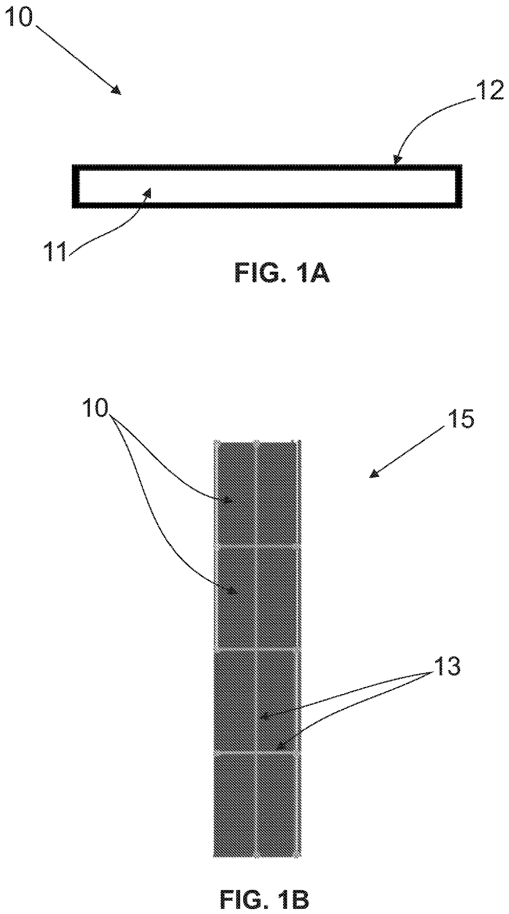

According to a preferred embodiment and as illustrated in Figures 1A and 1B, the p-n type photovoltaic cell 10, the subject of this invention, comprises a crystalline silicon structure 11 that is coated with a conductive film 12 formed from a p-type dopant solution and an n-type dopant solution.

The p-type and n-type dopant solutions comprise, in addition to the dopant elements, carotenoid components as described in detail below.

In this regard, the p-type dopant solution comprises a dopant element from group 5A of the periodic table, preferably phosphorus, in an amount of 1.5 to 4% by mass. The n-type dopant solution, on the other hand, comprises a dopant element from group 2A of the periodic table, preferably calcium, in an amount of 0.5 to 2% by mass.

The p-type and n-type dopant solutions further comprise isopropyl alcohol in amounts of 50% to 70% by mass, colophony resin in amounts of 15 to 30% by mass, cationic fluorocarbon surfactant in amounts of 0.5 to 2% by mass, liquid glycerin in amounts of 0.5 to 2.5% by mass, and silver nitrate in amounts of 1.5 to 4% by mass.

Further, for the formation of the conductive film 12, the p-type and n-type dopant solutions comprise carotenoids in an amount of 1 to 5% by mass in each solution. Carotenoids are natural pigments, with a high capacity to absorb solar radiation, and also act as an ultraviolet filter. These carotenoids are preferably selected from a group comprising bixin, norbixin, lycopene, canthaxanthin, fucoxanthin, and beta-carotene.

A p-n 10 photovoltaic cell, when exposed to sunlight, will produce an electric current. The silicon atom present in the crystalline silicon structure 11 has exactly four electrons in its last electronic layer. Phosphorus, present in conductive film 12, as an n-type dopant element, has five electrons, so the phosphorus atoms will have four of their electrons shared, leaving one electron that is not part of a covalent bond, but is still attracted by the positive charge of the phosphorus nucleus. Thus, the phosphorus electrons that are not part of a covalent bond can easily break their bond with the phosphorus nucleus, and a low energy is sufficient for this. In this case, these electrons are considered free, and the crystalline silicon structure 11, doped by the n-type dopant element present in the conductive film 12, now has an n-type electronic layer.

Calcium, in turn, has two electrons in the last electronic layer and therefore, when replacing a silicon atom will form a "hole" that will be defined as the absence of two negative charges, forming the p-type electronic layer.

By putting the two electronic layers, n-type and p-type, in contact, electrons flow from regions of low electronic concentration to regions of high electronic concentration. When electrons leave the n-type side there is a build-up of positive charge on the p-n contact boundary, likewise a build-up of negative charge on the p-type side. This charge imbalance that occurs at the boundary of the p - n type connection will be responsible for the appearance of an electric field that will oppose the natural tendency of electron diffusion and holes and, thus, an balance situation will be reached.

At the moment the sunlight formed by photons falls on the p-n type photovoltaic cell, there will be the formation of electron-hole pairs. For every photon that has enough energy to make the electrons flow from one electronic layer to the other, there will be the formation of an electron and a hole. Under these conditions the electrons produced will flow to the n-type side and the holes will flow to the p-type side, and this flow of electrons will be responsible for the emergence of an electric current. As the electric field of the cell will provide the potential difference, it will be possible to generate power, which is exactly the product of these two physical quantities.

Photons with energy higher than that required to make electrons flow from one electronic layer to the other, that is, photons holding energy near the ultraviolet light region, with higher frequency, grant excess energy that will be transformed into heat. Similarly, photons with energy lower than that required to make the electrons flow from one electronic layer to the next, that is, photons holding energy near the infrared region of light, with lower frequency, do not provide enough energy for the release of the electrons from their orbit and, as a result, this energy is converted into heat.

In these two situations described above, the heat generated causes p-n type photovoltaic cells 10 and with crystalline silicon structure 11 to lose efficiency, because the cell voltage is reduced and, therefore, the power it can generate is also reduced.

With the presence of carotenoids in the p-type and conductive film type 12 doping solutions, the efficiency of the p-n type 10 photovoltaic cell is increased. This is because carotenoids help to absorb sunlight and, in addition, they have a high capacity for absorbing solar radiation, especially ultraviolet radiation.

By absorbing the excess energy produced by ultraviolet rays, the carotenoids prevent the generation of heat in the p-n 10 photovoltaic cell and also absorb the excess energy in the ultraviolet region, forming a new electronic flux directed to the conduction bands of the p-n 10 photovoltaic cell. More specifically, electrons from the carotenoid molecule itself are transferred to the so-called conduction band, consequently, the electric current is increased and with it, the cell's 10 power is increased.

To have a photovoltaic system, as illustrated in Figure 1A, it is necessary to construct modules consisting of the union of a plurality of photovoltaic cells of the p-n 10 type, where this union is made through tin solder 13. To avoid problems in the solder region 13, cell 10 needs to be free of impurities, especially in this junction region. Thus, isopropyl alcohol added to the p-type and n-type dopant solutions provides the elimination of impurities that may interfere with the electrical conductivity of the cell 10 and the complete elimination of residual water.

In addition, the colophony resin and glycerin work so that the solder spreads evenly. Thus, at the time of soldering the tin flows freely into the parts to be soldered. Silver nitrate, on the other hand, is an excellent energy conductor and is present in both p-type and n-type dopant solutions to improve the energy performance in the junction region of the cells 10.

Consequently, the presence of the tin solder 13 at the junction of a plurality of p-n type photovoltaic cells 10 provides electrical conductivity between the joined cells 10, avoiding, for example, regions of electrical isolation that impact power generation.

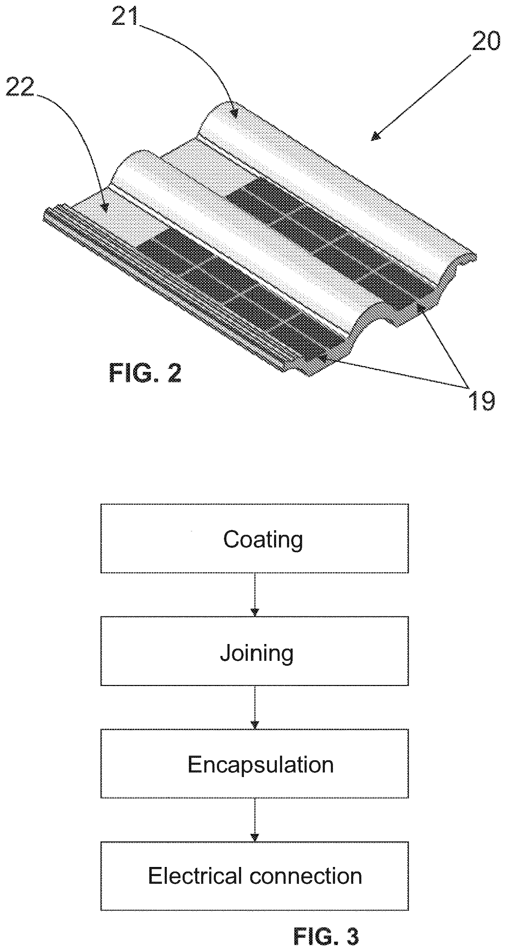

It is also an object of this invention, a process for manufacturing an encapsulated p-n 10 type photovoltaic cell, as illustrated in Figure 3. This process comprises the following steps:
a) coating of a plurality of crystalline silicon structures 11 by a conductive film 12 formed from p-type and n-type dopant solutions comprising carotenoid components, forming a plurality of p-n-type photovoltaic cells 10;
b) joining the plurality of p-n type photovoltaic cells 10 by tin soldering 13 to form a module 15;
c) encapsulation of module 15 forming an encapsulated photovoltaic cell 19; and
d) electrical connection.

### a) Coating step

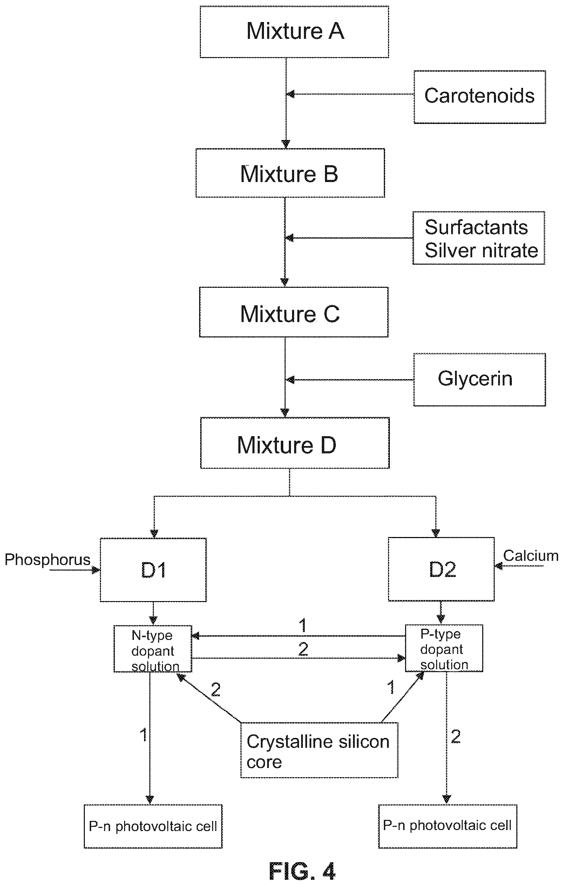

The step of coating a plurality of crystalline silicon structures 11 by a conductive film 12 formed from p-type and n-type dopant solutions comprises a mixture of one part colophony resin to three parts isopropyl alcohol forming a mixture A, the addition of one part carotenoids to sixteen parts of mixture A forming a homogeneous mixture B, adhesion of one part cationic fluorocarbon surfactant to eighty-five parts of mixture B and three parts silver nitrate to one part cationic fluorocarbon surfactant forming a mixture C and addition of one part glycerin to every forty-four parts of mixture C forming a mixture D (figure 4).

Once mixture D is formed, it is separated into mixture D1 and mixture D2, in equal parts. In mixture D1 there is a step of adding one part phosphorus to fifteen parts of mixture D1 forming the n-type dopant solution. In mixture D2 there is a step of adding one part calcium to forty-five and a half parts of mixture D2 forming the p-type dopant solution.

Next, the crystalline silicon structures 11 are immersed in the p-type dopant solution and then immersed in the n-type dopant solution, according to route 1 in figure 4. Optionally, crystalline silicon structures 11 can be immersed in the n-type dopant solution and then immersed in the p-type dopant solution, according to route 2 in figure 4. At the end of this step the p-n type photovoltaic cells 10 are obtained, which are then taken to the final drying step to form the conductive film 12.

### b) Step of joining the plurality of p-n photovoltaic cells

In this step, a plurality of p-n type photovoltaic cells 10 is positioned in series forming a cluster of at least seven cells 10, which will be joined together to form a module 15 (figure 1B).

The joint is made by means of tin solder 13 so as to allow the joint region not to compromise the electrical conductivity of the module 15.

### c) Module encapsulation step

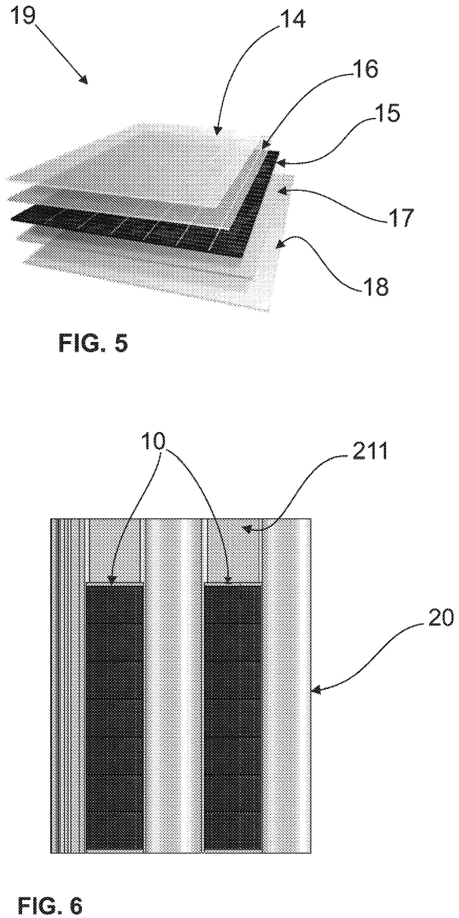

The module 15 formed is then encapsulated. As illustrated in figure 5, initially, above module 15 a first layer of EVA polymer 16 is positioned forming the negative side. Below module 15, a second layer of EVA polymer 17 is positioned, followed by a protective bottom layer 18 of TPT (Tedlar Polyester Tedlar) material, forming a positive side.

After positioning these layers above and below the module 15, the encapsulation is done, which consists of submitting this assembly to vacuum in a lamination equipment. This encapsulation provides corrosion protection and waterproofing.

Finally, the encapsulated assembly is submitted to a resin coating, which consists of applying a layer of resin, for example translucent epoxy resin, over the negative part formed by the first EVA polymer layer 16, forming a resin layer 14.

The result of this step is an encapsulated photovoltaic cell 19.

### d) Electrical connection

The encapsulated photovoltaic cell 19 receives a junction box (not shown) positioned on the outer surface of the protective background layer 18. This junction box is intended to allow the encapsulated photovoltaic cell 19 to be connected to a current converter (not shown) during use. However, a preferred embodiment of electrical connection will be described in detail later.

Another object of this invention consists of a photovoltaic tile 20, illustrated in Figure 2. The photovoltaic tile 20 is preferably made of concrete or fiber cement, but can also be made of other materials such as ceramics and polymers, and receives a plurality of encapsulated photovoltaic cells 19 in order to form a photovoltaic system.

The photovoltaic tile 20 may have a corrugated shape containing at least one corrugation 21 followed by at least one plateau 22, a corrugated shape 21 without the presence of the plateaus, or other numerous shapes. The encapsulated photovoltaic cells 19 are fixed on the roof tiles 20, preferably by means of gluing with polyurethane glue, and other types of fixation can be used, such as adhesives, screws, rivets, among others, so that the encapsulated photovoltaic cells 19 form, with the photovoltaic tile 20, single handles containing two functions: roofing and generation of electric energy. For this, they do not require a fixation system with aluminum profiles and extra structures to be fixed on the roofs for the photovoltaic system, the usual timbering or metal structure for roofs being enough, since the tile itself to be used as a roof already comprises photovoltaic cells in its constitution.

In particular, the encapsulated photovoltaic cells 19 may be attached to the plateaus 22 of the photovoltaic tile 20, on the corrugations 21 of the photovoltaic tile 20, in valleys (not shown) formed between two subsequent corrugations 21, on the side walls of the corrugations 21, or other points on the surface of the photovoltaic tile 20.

The photovoltaic tile 20, object of this invention, solves the aesthetic-functional problem of conventional photovoltaic panels, solves fixation problems, facilitates installation and maintenance on the roof, increases the durability of the roof, allows the installation of a photovoltaic system in projects where there are restrictions on adding weight to the roof structure, and reduces the use of materials, reducing the cost of a photovoltaic system.

Regarding the electrical connection, preferably and as illustrated in Figures 6, 7 and 8 and Figure 8A, the electrical connection assembly for photovoltaic tile 20 comprises a first main connector 121 embedded in the photovoltaic tile 20, particularly on a rear surface 221 of the photovoltaic tile 20, opposite the photovoltaic cell 10, wherein the electrical connection assembly comprises a first main connector 121 for each photovoltaic cell 10 of the photovoltaic tile 20.

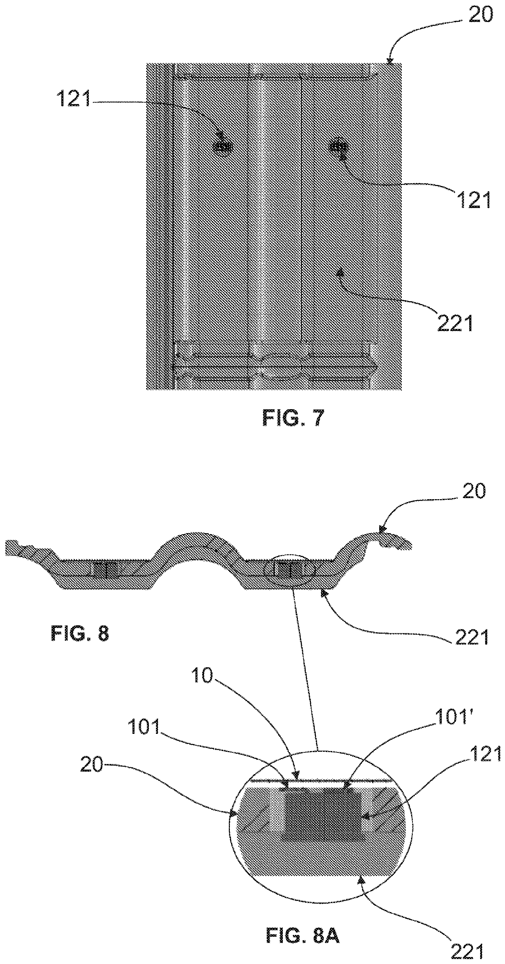

As can be seen in Figure 8A, each first main connector 121 embedded in the back surface 221 of the photovoltaic tile 20 is associated with electrical busbars 101, 101' of the photovoltaic cell 10, which is attached to the front surface 211 of the tile 20, so that the electrical energy generated by the photovoltaic cell 10 is directed to the first main connector 121.

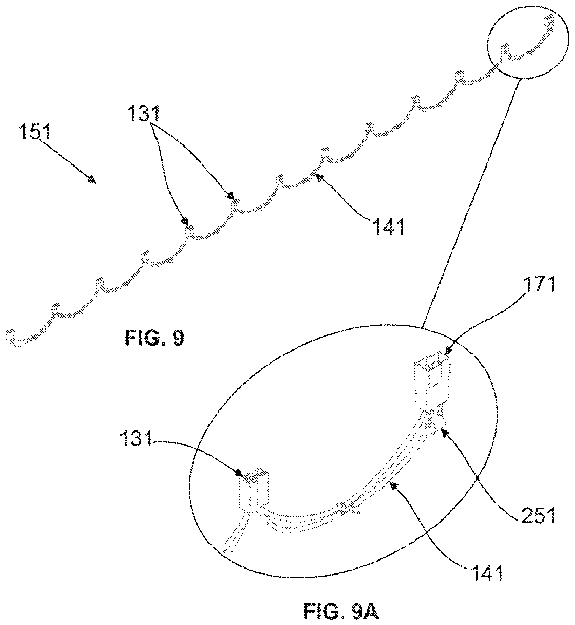

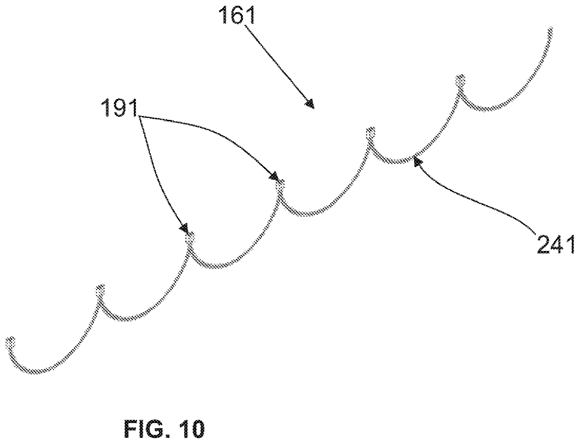

As illustrated in Figure 9 and Figure 10, the electrical connection assembly preferably comprises a plurality and second main connectors 131 connected to a pair of main conductor wires 141, forming a main conductor line 151. Each second main connector 131 is covered with a polymeric insulation of high dielectric strength, mechanical rigidity, and thermal insulation.

More specifically and as can be seen in Figure 9 and Figure 9A, the plurality of second main connectors 131 is spaced connected to a pair of main conductor wires 141, with the spacing between the subsequent second main connectors 131 coinciding with the spacing between the subsequent first main connectors 121 embedded in the photovoltaic tiles 20. Furthermore, the number of second main connectors 131 connected to the main conductor wires 141 forming the main conductor line 151 varies depending on the number of photovoltaic tiles 20 that will be interconnected in line.

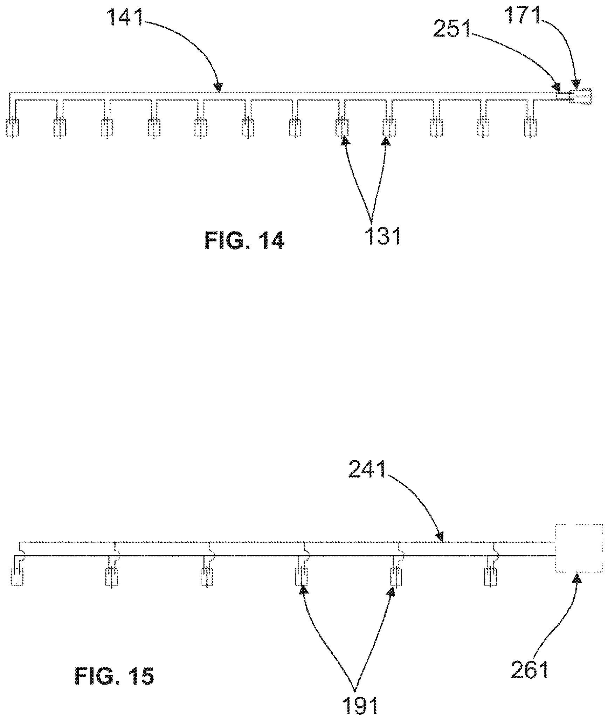

Thus, Figure 9 and the wiring diagram of Figure 14 illustrate a plurality of second main connectors 131 spaced apart connected to a pair of main conductor wires 141 forming the main conductor line 151 which comprises, at its end, a connection terminus 171 provided with at least one diode 251. The function of diode 251 is to prevent reverse current from occurring.

Each main conductor line 151 interconnects a line or row of photovoltaic tiles 20 with each other, from the fitting of the second main connectors 131 into the first main connectors 121, leaving free at the end of the line of tiles 20, the connection terminal 171 and so on in each row or row of tiles 20 assembled and interconnected with a main conductor line 151.

The second main connector 131 is fitted and electrically associated with the first main connector 121, so as to conduct the electrical energy generated by at least one photovoltaic cell 10 and received by the first main connector 121 to the connection terminal 171 via the pair of main conductor wires 141.

Figure 10 and diagram 15 illustrate, in turn, at least one and preferably a plurality of secondary connectors 191 connected to a pair of secondary conductive wires 241 forming a secondary conductor line 161. The function of this secondary conducting line 161 is to interconnect the lines or rows of tiles 20 to an inverter element 261 or a micro inverter.

So, each secondary connector 191 of the secondary conductor line 161 is associated or connected to a connecting terminal 171 of a main conductor line 151 conducting the electrical energy generated in the photovoltaic tiles 20 to the inverter element 261.

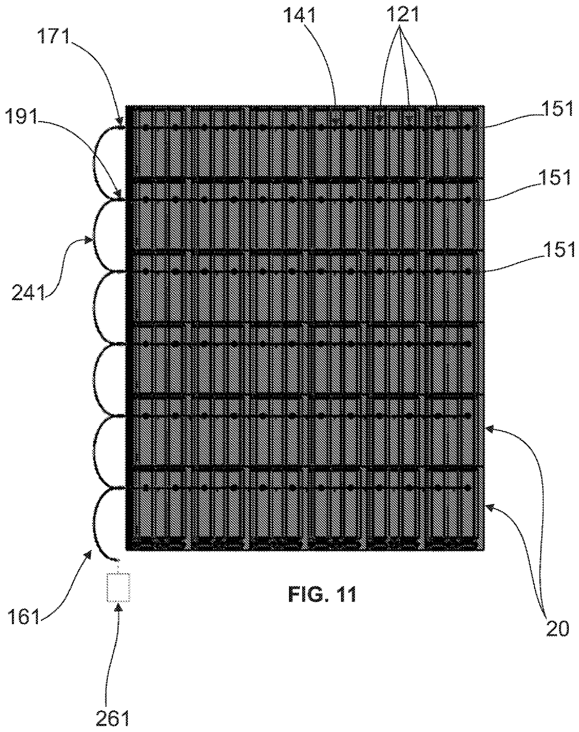

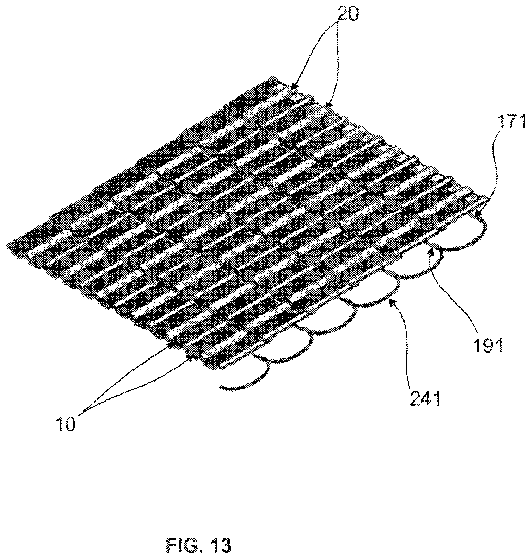

In this regard, as can be seen in figures 11, 12 and 13, the first main connectors 121 are embedded in the photovoltaic tiles 20, without any exposed terminals or cables, providing safety for handling these tiles 20, with no risk of electrical shock. As already described, each first main connector 121 is embedded in the back surface 221 of the photovoltaic tile 20 in order to receive the electrical energy generated by the photovoltaic cells 10.

After the photovoltaic tiles 20 are installed in rows or rows on the roof of interest, the second main connectors 131 are fitted, one to each first main connector 121 of the tiles 20, in rows, as illustrated in Figure 11.

Once the fittings have been completed on the multiple rows that make up the desired cover, the connecting terminals 171 of the main conductor lines 151 are connected to the secondary connectors 191 of the secondary conductor line 161 and the end of that secondary conductor line 161 is associated with the inverter element 261.

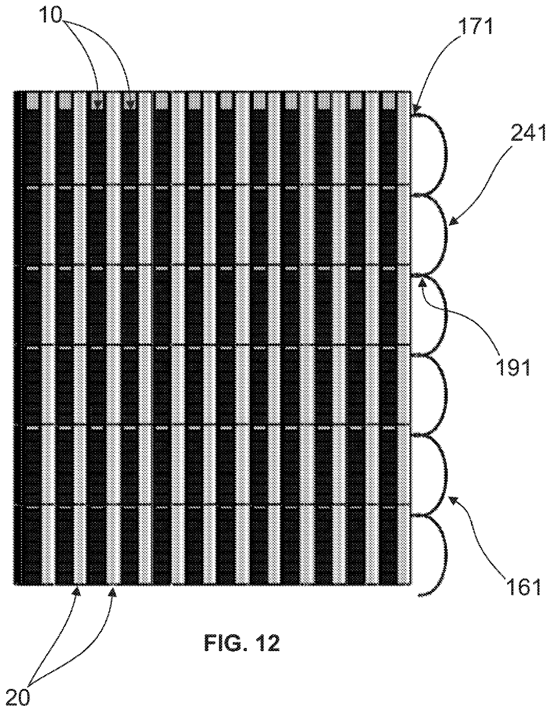

Figure 12 illustrates these same connections illustrated in Figure 11, but viewed from above. In this case it can be seen that the main conductor wire pairs of the main conductor lines 151 are protected by the 20 tiles, so they do not need to be made of UV-protected material, since they are not exposed to the sun, since the electrical conduction between the 20 tiles is done under the roof, and does not suffer the incidence of ultraviolet rays.

All connectors, main and secondary, have 8mm terminals, supporting an electrical current of 70 amperes. In addition, they are made of tinned brass, which is a very conductive material for electrical energy and highly resistant to corrosion.

The connection of the first main conductors 121 with the second main conductors 131 has the presence of claws on the first main conductors 121, in addition to claws on the sleeves of the second main conductors 131, preventing disconnections and poor contacts, preventing arcs and eliminating risks of fire.

With the use of the electrical connection set for photovoltaic tile 20, object of this invention, there is a practicality in the installation of the photovoltaic tiles 20, making electrical connection errors impossible, that is, it is enough to install the tiles 20 in the desired roof space, the connection or plug of the second main conductors 131 in the first main conductors 121 and the connection or plug of the secondary connectors 191 of the secondary conductor line 161 in the connection terminals 171 for the photovoltaic tiles 20 to work and the electrical energy generated by them to be captured in a satisfactory manner.

It is also an object of this invention a photovoltaic tile 20 containing the electrical connection assembly for photovoltaic tile 20 described above.

Therefore, the installation of photovoltaic tiles 20 containing the electrical connection set for photovoltaic tile 20 eliminates the need to use components such as MC4 type terminals and junction boxes, which are widely used in this type of connection, however, without making the electrical connection of the tiles 20 unsafe, since the electrical connection set prevents the formation of electric arcs, bad contacts and electric shocks. Fire hazards are also eliminated.

Another advantage of the electrical connection set for photovoltaic tile 20 is the simplicity of the electrical connections, dispensing with specialized labor for the installation of the tiles 20 and the electrical connection set.

Having described an example of preferred embodiment, it should be understood that the scope of the present invention encompasses other possible variations, being limited solely by the content of the appended claims, including possible equivalents therein.

## Claims

1. P-N type photovoltaic cell (10), **characterized in that** it comprises a crystalline silicon structure (11) coated with a conductive film (12) formed from a p-type doping solution and an n-type doping solution, the doping solutions of the p-type of the n-type comprising carotenoid components.

2. Photovoltaic cell according to claim 1, **characterized in that** the p-type dopant solution comprises a group 5A dopant element and the n-type dopant solution comprises a 2A group dopant element of the periodic table.

3. Photovoltaic cell according to claim 2, **characterized in that** the group 5A dopant is the phosphorus in an amount of 1.5 to 4% and the group 2A dopant is the calcium in an amount of 0.5 to 2% .

4. Photovoltaic cell according to claim 2, **characterized in that** the p-type doping solution and the n-type solution further comprise colophony resin in an amount of 15 to 30% by weight, fluorocarbon cationic surfactant in an amount of 0. 5 to 2%, liquid glycerin in an amount of 0.5 to 2.5% and silver nitrate in an amount of 1.5 to 4%.

5. Photovoltaic cell, according to claims 1 to 4, **characterized by** the fact that carotenoids are present in the p-type dopant solution and in the n-type dopant solution in an amount of 1 to 5% by weight in each solution.

6. Photovoltaic cell according to claim 5, **characterized in that** the carotenoids are selected from a group comprising bixin, norbixin, lycopene, canthaxanthin, fucoxanthin and beta-carotene.

7. Manufacturing process of encapsulated p-n type photovoltaic cell, **characterized by** the fact that it comprises the following steps:
a) coating a plurality of crystalline silicon structures (11) by a conductive film (12) formed from p-type and n-type doping solutions comprising carotenoid components, forming a plurality of p-n type photovoltaic cells (10);
b) joining of the plurality of photovoltaic cells of the p-n type (10) by means of tin soldering (13) forming a module (15);
c) encapsulation of the module (15) forming an encapsulated photovoltaic cell (19); and
d) electrical connection.

8. Process according to claim 7, **characterized in that** the step of coating a plurality of crystalline silicon structures (11) by a conductive film (12) comprises the following steps:
(i) mixture of colophony resin and isopropyl alcohol forming a mixture A;
(ii) addition of carotenoids in mixture A forming a homogeneous mixture B;
(iii) addition of cationic fluorocarbon surfactant and silver nitrate to mixture B forming a mixture C;
(iv) adding glycerin to mixture C forming a mixture D;
(v) separation of mixture D into mixtures D1 and D2, addition of phosphorus in mixture D1 forming the n-type doping solution and addition of calcium in mixture D2 forming the p-type doping solution;
(vi) immersion of the plurality of crystalline silicon structures (11) in p-type and n-type doping solutions forming p-n type photovoltaic cells (10);
(vii) drying of the p-n type photovoltaic cells (10) forming the conductive film (12).

9. Electrical connection assembly for photovoltaic tile (20), said photovoltaic tile (20) fitted with photovoltaic cells (10), the electrical connection assembly being **characterized by** comprising:
at least one first main connector (121) embedded in the photovoltaic tile (20) and associated with electrical busbars (101, 101') of at least one photovoltaic cell (10); and
at least a second main connector (131) connected to a pair of main conductor wires (141) forming a main conductor line (151),
the at least one second main connector (131) being electrically associated with the at least one first connector (121) in order to conduct electrical power generated by the at least one photovoltaic cell (10) to an inverter element (261).

10. Electrical connection assembly according to claim 9, **characterized in that** it further comprises at least one secondary connector (191) connected to a pair of secondary conductive wires (241) forming a secondary conductor line (161).

11. Electrical connection assembly according to claim 9, **characterized in that** the main conductor line (151) comprises a connecting terminal (171) provided with at least one diode (251).

12. Electrical connection assembly according to claims 10 and 11, **characterized in that** at least one secondary connector (191) of the secondary conductor line (161) is associated with the connecting terminal (171) of the main conductor line (151).

13. Electrical connection assembly according to claim 12, **characterized in that** the secondary conductor line (161) is connected to the inverter element (261).

14. Electrical connection assembly according to claim 9, **characterized in that** it comprises a first main connector (121) for each photovoltaic cell (10) of the photovoltaic tile (20).

15. Electrical connection assembly according to claim 14, **characterized in that** it comprises a second main connector (131) electrically associated with each first main connector (121).

16. Electrical connection assembly according to claim 15, **characterized in that** each second main connector (131) is coated with a polymeric insulation of high dielectric strength, mechanical rigidity and thermal insulation.

17. Electrical connection assembly according to claim 14, **characterized in that** at least one first main connector (121) is embedded in a rear surface (221) of the photovoltaic tile (20), opposite the photovoltaic cell (10).

18. Photovoltaic tile (20), **characterized in that** it comprises an electrical connection assembly for photovoltaic tiles as defined in claims 10 to 17 and a plurality of encapsulated photovoltaic cells (19) as defined in claims 7 and 8.
